# EUROPÄISCHE PATENTSCHRIFT

(11) **EP 3 304 605 B1**
(45) Veröffentlichungstag und Bekanntmachung des Hinweises auf die Patenterteilung: **27.11.2019**
(21) Anmeldenummer: 16725129.7
(22) Anmeldetag: 25.05.2016
(51) Int. Cl.: H01L 33/44, H01L 33/48

(54) **OPTOELEKTRONISCHES BAUELEMENT UND VERFAHREN ZUR HERSTELLUNG EINES OPTOELEKTRONISCHEN BAUELEMENTS**
OPTOELECTRONIC COMPONENT, AND METHOD FOR PRODUCING AN OPTOELECTRONIC COMPONENT
COMPOSANT OPTOÉLECTRONIQUE ET PROCÉDÉ DE FABRICATION D'UN COMPOSANT OPTOÉLECTRONIQUE

(30) Priorität: 02.06.2015 DE 102015108736
(43) Veröffentlichungstag der Anmeldung: 11.04.2018
(73) Patentinhaber: OSRAM Opto Semiconductors GmbH, 93055 Regensburg (DE)
(72) Erfinder: LINDBERG, Gudrun, Bad Abbach 93077 (DE)
(74) Vertreter: Epping - Hermann - Fischer
(86) Internationale Anmeldenummer: PCT/EP2016/061806
(87) Internationale Veröffentlichungsnummer: WO 2016/193098

(56) Entgegenhaltungen:
- WO-A-2015/044529
- WO-A1-2015/024120
- US-A1- 2010 230 696
- US-A1- 2014 291 658

## Beschreibung

Die Erfindung betrifft ein optoelektronisches Bauelement. Ferner betrifft die Erfindung ein Verfahren zur Herstellung eines optoelektronischen Bauelements.

Metallische Oberflächen von optoelektronischen Bauelementen zeigen oft Korrosion aufgrund von stark korrosiv wirkenden Gasen, die in das optoelektronische Bauelement eindringen und so in Berührung mit den metallischen Oberflächen kommen können. Dies kann zu einem unerwünschten Bauteilausfall führen.

WO 2015/044529 A beschreibt eine Verkapselungsschicht mit multifunktionellem Verwendungszweck und ein Herstellungsverfahren dafür.

US 2014/291658 A1 beschreibt ein optoelektronisches Bauelement mit einer Außenfläche, die zumindest teilweise durch eine hydrophobe Schicht gebildet ist. US 2010/230696 A1 beschreibt ein optoelektronisches Bauelement mit einer Schutzschicht.

Eine Aufgabe der Erfindung ist es, ein stabiles optoelektronisches Bauelement bereitzustellen. Eine weitere Aufgabe ist es, ein langlebiges optoelektronisches Bauelement bereitzustellen.

Diese Aufgaben werden durch ein optoelektronisches Bauelement gemäß dem unabhängigen Anspruch 1 gelöst. Vorteilhafte Ausgestaltungen und Weiterbildungen der Erfindung sind Gegenstand der abhängigen Ansprüche. Ferner werden diese Aufgaben durch ein Verfahren zur Herstellung eines optoelektronischen Bauelements gemäß dem Anspruch 8 gelöst.

Vorteilhafte Ausgestaltungen und Weiterbildungen des Verfahrens sind Gegenstand der abhängigen Ansprüche 9 bis 12.

Das optoelektronische Bauelement weist zumindest eine metallische Oberfläche auf. Das optoelektronische Bauelement umfasst einen kontaktierten optoelektronischen Halbleiterchip. Der kontaktierte optoelektronische Halbleiterchip ist zur Emission von Strahlung eingerichtet. Das optoelektronische Bauelement umfasst eine Schutzschicht. Die Schutzschicht ist auf der zumindest einen metallischen Oberfläche angeordnet. Die Schutzschicht umfasst ein Schutzmaterial aus zumindest einem N-heterozyklischen Carben. Zwischen dem Schutzmaterial und der zumindest einen metallischen Oberfläche ist eine kovalente Bindung ausgebildet.

Denkbar wäre auch die Nutzung kostengünstiger Thiol-basierter selbstorganisierender Monoschichten (SAM, self-assembly monolayers) als Schutzmaterial statt eines N-heterozyklischen Carbens als Schutzmaterial. Bei der Verwendung von Thiolbasierten SAMs muss allerdings mit einer deutlich verminderten Hitze- und Chemikalienbeständigkeit gerechnet werden.

Gemäß zumindest einer Ausführungsform handelt es sich bei dem optoelektronischen Bauelement um eine Leuchtdiode, kurz LED. Das optoelektronische Bauelement weist insbesondere einen kontaktierten optoelektronischen Halbleiterchip auf. Der Halbleiterchip ist dann bevorzugt dazu eingerichtet, blaues Licht oder weißes Licht zu emittieren.

Es sei an dieser Stelle darauf hingewiesen, dass hier unter dem Begriff "optoelektronisches Bauelement" nicht nur fertige Bauelemente, wie beispielsweise Leuchtdioden (LEDs) oder Laserdioden, zu verstehen sind, sondern auch Substrate und/oder Halbleiterschichten, sodass beispielsweise bereits ein Verbund einer Kupferschicht und einer Halbleiterschicht ein Bauelement darstellen und einen Bestandteil eines übergeordneten zweiten Bauelements bilden kann, in dem beispielsweise zusätzlich elektrische Anschlüsse vorhanden sind.

Gemäß zumindest einer Ausführungsform weist das optoelektronische Bauelement einen kontaktierten optoelektronischen Halbleiterchip auf. Der Halbleiterchip umfasst eine Halbleiterschichtenfolge. Die Halbleiterschichtenfolge des Halbleiterchips basiert bevorzugt auf einem III-V-Verbindungshalbleitermaterial. Bei dem Halbleitermaterial handelt es sich bevorzugt um ein Nitrid-Verbindungshalbleitermaterial wie AlₙIn₁₋ₙ₋ₘGaₘN oder auch um ein Phosphid-Verbindungshalbleitermaterial wie AlₙIn₁₋ₙ₋ₘGaₘP, wobei jeweils 0 ≤ n ≤ 1, 0 ≤ m ≤ 1 und n + m ≤ 1 ist. Ebenso kann es sich bei dem Halbleitermaterial um AlₓGa₁₋ₓAs handeln mit 0 ≤ x ≤ 1. Dabei kann die Halbleiterschichtenfolge Dotierstoffe sowie zusätzliche Bestandteile aufweisen. Der Einfachheit halber sind jedoch nur die wesentlichen Bestandteile des Kristallgitters der Halbleiterschichtenfolge, also Al, As, Ga, In, N oder P, angegeben, auch wenn diese teilweise durch geringe Mengen weiterer Stoffe ersetzt und/oder ergänzt sein können.

Die Halbleiterschichtenfolge beinhaltet eine aktive Schicht mit mindestens einem pn-Übergang und/oder mit einer oder mit mehreren Quantentopfstrukturen. Im Betrieb des Halbleiterchips wird in der aktiven Schicht eine elektromagnetische Strahlung erzeugt. Eine Wellenlänge oder das Wellenlängenmaximum der Strahlung liegt bevorzugt im ultravioletten und/oder sichtbaren Spektralbereich, insbesondere bei Wellenlängen zwischen einschließlich 420 nm und 680 nm, zum Beispiel zwischen einschließlich 440 nm und 480 nm.

Der optoelektronische Halbleiterchip ist kontaktiert. Damit ist hier und im Folgenden gemeint, dass der optoelektronische Halbleiterchip zumindest zwei Anschlussstellen, insbesondere einen p-Anschlusskontakt und einen n-Anschlusskontakt aufweist, die die Halbleiterschichtenfolge elektrisch kontaktieren. Mit anderen Worten weist das optoelektronische Bauelement einen Halbleiterchip auf, der betriebsfähig ist. Der Halbleiterchip ist zur Emission von Strahlung eingerichtet. Insbesondere ist der aktive Bereich der Halbleiterschichtenfolge zur Emission von Strahlung eingerichtet.

Gemäß zumindest einer Ausführungsform weist das optoelektronische Bauelement zumindest eine metallische Oberfläche auf. Insbesondere kann das optoelektronische Bauelement mehrere metallische Oberflächen aufweisen. Mit metallischen Oberflächen sind jegliche Oberflächen aus Metall oder zumindest einer Legierung zu verstehen, die befähigt ist, mit dem Schutzmaterial eine kovalente Bindung auszubilden.

Gemäß zumindest einer Ausführungsform ist die metallische Oberfläche aus einer Gruppe ausgewählt, die eine Oberfläche eines ersten metallischen Anschlusskontakts, eines zweiten metallischen Anschlusskontakts, eines Leiterrahmens, eines Bondpads und eines Bonddrahts umfasst. Insbesondere weist die metallische Oberfläche zumindest ein Metall oder eine Legierung auf, die ausgewählt ist aus: Silber, Aluminium, Cadmium, Barium, Indium, Magnesium, Kalzium, Lithium, Gold oder Kombinationen daraus. Insbesondere kann die metallische Oberfläche eine Legierung aufweisen oder daraus bestehen, beispielsweise aus: Ag:Mg, Ag:Ca, Mg:Al.

Gemäß zumindest einer Ausführungsform weist das optoelektronische Bauelement eine Schutzschicht auf. Die Schutzschicht ist zumindest auf der einen metallischen Oberfläche oder auf mehreren metallischen Oberflächen angeordnet. Dass eine Schicht oder ein Element "auf" oder "über" einer anderen Schicht oder einem anderen Element angeordnet oder aufgebracht ist, kann dabei hier und im Folgenden bedeuten, dass die eine Schicht oder das eine Element unmittelbar in direktem mechanischem und/oder elektrischem Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht beziehungsweise zwischen dem einen und dem anderen Element angeordnet sein.

Gemäß zumindest einer Ausführungsform bedeckt die Schutzschicht die metallische Oberfläche formschlüssig. Mit "formschlüssig" ist hier gemeint, dass die Schutzschicht sich an die Gestalt oder Form der metallischen Oberfläche anpasst. Dabei ist insbesondere ein direkter mechanischer Kontakt zwischen der metallischen Oberfläche und der Schutzschicht vorhanden. Ist beispielsweise die metallische Oberfläche ein Bonddraht, so ummantelt die Schutzschicht den Draht von allen Seiten. Damit kann verhindert werden, dass korrosive Gase an den Bonddraht gelangen und diesen korrodieren. Es kann damit die Lebenszeit des Bauelements verlängert werden.

Die Schutzschicht. weist ein Schutzmaterial aus zumindest einem N-heterozyklischen Carben auf. Insbesondere besteht die Schutzschicht aus einem Schutzmaterial aus zumindest einem N-heterozyklischen Carben. Alternativ kann statt einem N-heterozyklischen Carben auch eine Mischung mehrerer N-heterozyklischer Carbene als Schutzmaterial in der Schutzschicht des optoelektronischen Bauelements vorhanden sein.

Das Schutzmaterial besteht aus zumindest einem N-heterozyklischen Carben, wobei das N-heterozyklische Carben 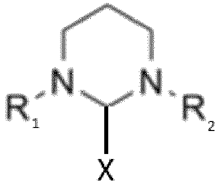 ist, wobei R₁ und R₂ unabhängig voneinander ausgewählt sind, aus Wasserstoff, Alkylgruppen, Alkoxygruppen, Gruppen mit unsubstituierten Aromaten, substituierten oder unsubstituierten Heteroaromaten, Halogenen, Pseudohalogenen und Kombinationen daraus. Das in den einzelnen Formeln dargestellte -X zeigt dabei jeweils eine kovalente Bindung zur zumindest einen metallischen Oberfläche X.

Gemäß zumindest einer Ausführungsform ist die Schutzschicht als selbstorganisierende Monolage oder Monoschicht (self-assembly monolayers, kurz SAM) ausgeformt. Insbesondere weist die Monolage eine Schichtdicke von kleiner oder gleich 10 nm, insbesondere kleiner oder gleich 5 nm, insbesondere kleiner oder gleich 1 nm, beispielsweise 0,4 nm, auf. Mit Monolage oder Monoschicht wird hier eine Schicht von Atomen oder Molekülen auf einer metallischen Oberfläche bezeichnet, wobei die Schichtdicke nur ein Atom oder ein Molekül beträgt.

Gemäß zumindest einer Ausführungsform ist das Schutzmaterial frei von Schwefel. Damit ist gemeint, dass die N-heterozyklischen Carbene keine Schwefelatome aufweisen. Dadurch erfolgt keine kovalente Anbindung des N-heterozyklischen Carbens an die Metalloberfläche über ein Schwefelatom.

Gemäß zumindest einer Ausführungsform weist das Schutzmaterial eine Seitenkette oder Seitenketten auf, die Schwefel umfassen. Die kovalente Anbindung des N-heterozyklischen Carbens an die metallische Oberfläche erfolgt über ein Kohlenstoff-Atom des Carbens. Mit anderen Worten erfolgt keine kovalente Anbindung des N-heterozyklischen Carbens an die metallische Oberfläche über ein Schwefel-Atom der Seitenkette oder Seitenketten. Insbesondere erfolgt die kovalente Anbindung des N-heterozyklischen Carbens an die metallische Oberfläche über ein Kohlenstoff, insbesondere über ein Kohlenstoffatom. Mit anderen Worten bildet sich eine kovalente Bindung zwischen einem Metall der metallischen Oberfläche und dem Kohlenstoff des N-heterozyklischen Carbens aus. Insbesondere erfolgt die kovalente Anbindung über das Kohlenstoff-Atom des Carbens im Fünfring, das zwischen benachbarter Stickstoffatome angeordnet ist. Insbesondere erfolgt die kovalente Anbindung über das nichtbindende Elektronenpaar des zweibindingen Carbenkohlenstoffs, welcher sich in direkter Umgebung zwischen zwei beanchbarten Stickstoffatomen befindet. Das reaktive Carben kann durch die benachbarten Stickstoffatome, die als Donorsubstituenten fungieren, stabilisiert sein (Ylid-Form).

Carbene sind im Vergleich zu N-heterozyklischen Carbenen instabile, sehr reaktive Verbindungen eines zweiwertigen Kohlenstoffs mit Elektronensextett. Die erhöhte Stabilität von N-heterozyklischen Carbenen im Vergleich zu anderen Carbenen wird vor allem durch den -I-Effekt der benachbarten elektronegativen Substituenten, sowie deren Donorfunktion über das freie Elektronenpaar in das unbesetzte p-Orbital des Carbenkohlenstoffs, erreicht. N-heterozyklische Carbene sind insbeondere vom Arduengo-Typ. Neben Stickstoff können auch Schwefel oder Sauerstoff oder Phosphor das Carben stabilisieren. N-heterozyklische Carbene mit einem Imidazolgrundgerüst werden zusätzlich durch das sich mittels Mesomerieeffekten ausbildende π-System stabilisiert. Damit kann insbesondere eine Schutzschicht bereitgestellt werden, die stabil ist und zudem das optoelektronische Bauelement vor möglichen Umwelteinflüssen, beispielsweise Korrosion, schützt.

Gemäß zumindest einer Ausführungsform ist die Schutzschicht diffusionsdicht gegenüber korrosiven Gasen. Mit "diffusionsdicht" wird hier und im Folgenden gemeint, dass die Schutzschicht einen geringen Diffusionskoeffizienten für Gase, insbesondere für korrosiv wirkende Gase, beispielsweise Schwefelwasserstoff, aufweist. Aufgrund des geringen Diffusionskoeffizienten der Schutzschicht kann beispielsweise aus einem in einem Bauelement vorhandenen Verguss, der mit Schwefel vulkanisiertes Gummimaterial aufweist, zwar Schwefelwasserstoff entweichen, allerdings diffundiert dieser Schwefelwasserstoff nicht durch die Schutzschicht und führt damit nicht zur Korrosion von metallischen Oberflächen des optoelektronischen Bauelements. Damit kann die Langlebigkeit und die Stabilität des optoelektronischen Bauelements erhöht werden und unerwünschter Bauteilausfall vermieden werden.

Gemäß zumindest einer Ausführungsform sind alle metallischen Oberflächen des optoelektronischen Bauelements mit der Schutzschicht formschlüssig bedeckt. "Formschlüssig bedeckt" meint hier, dass die Schutzschicht die metallischen Oberflächen umhüllt oder darauf nachgeordnet ist, ohne aber deren Funktion zu beeinträchtigen. Das bedeutet beispielsweise, dass ein optoelektronisches Bauelement trotz vorhandener Schutzschicht Strahlung emittieren kann und Strom fließen kann. "Alle metallischen Oberflächen" meint hier insbesondere metallische Oberflächen von Anschlussstellen, metallische Oberflächen von Leadframes, Bonddrahts und/oder Bondpads.

Gemäß zumindest einer Ausführungsform ist der kontaktierte optoelektronische Halbleiterchip in einem Gehäuse angeordnet. Das Gehäuse weist eine Ausnehmung auf, in der der kontaktierte optoelektronische Halbleiterchip angeordnet ist. Das optoelektronische Bauelement weist metallische Oberflächen auf, die insbesondere zumindest metallische Oberflächen eines Bondpads, eines Bonddrahts und/oder eines Leiterrahmens sind oder diese umfasst. Die Schutzschicht ist dann auf den metallischen Oberflächen des Bondpads, des Bonddrahts und/oder des Leiterrahmens aufgebracht. Insbesondere bedeckt die Schutzschicht die metallischen Oberflächen des optoelektronischen Bauelements innerhalb der Ausnehmung formschlüssig. Die Ausnehmung kann alternativ oder zusätzlich mit einem Verguss vergossen sein. Als Verguss eignet sich Silikon, insbesondere silikonbasierte Materialien, wie beispielsweise methylsubstituiertes Silikon, phenylsubstituiertes Silikon oder methylphenylsubstituiertes Silikon.

Silikonmaterialien als Verguss zeigen den Vorteil, dass sie thermisch stabil sind und eine hohe optische Transparenz aufweisen. Allerdings weisen Silikonmaterialien im Vergleich zu Epoxidmaterialien eine gewisse Durchlässigkeit für Gase, insbesondere für korrosiv wirkende Gase, auf. Dies spielt vor allem im Betrieb von optoelektronischen Bauteilen eine Rolle, wenn es bei erhöhten Systemtemperaturen zu einem Ausgasen aggressiver Substanzen aus anderweitig anwesenden Materialien kommt.

Die Erfinderin hat nun erkannt, dass durch die Verwendung einer Schutzschicht auf metallischen Oberflächen eines optoelektronischen Bauelements die Beeinflussung, insbesondere die Korrosion, durch Diffusion korrosiv wirkender Gase durch eine Silikonverkapselung verhindert werden kann. Mit Hilfe der Schutzschicht, die insbesondere zumindest ein N-heterozyklisches Carben, insbesondere ein SAM aus einem N-heterozyklischen Carben, aufweist, kann die Korrosion von metallischen Oberflächen verhindert werden, und somit einer beschleunigten Bauteilalterung aktiv vorgebeugt werden. Dies bewirkt eine Langzeitstabilität des Bauelements. Insbesondere ist die Schutzschicht eine dauerhaft im Bauelement verbleibende Schicht. Daher ist es wichtig, dass es sich bei der auf der metallischen Oberfläche ausbildenden Schutzschicht, insbesondere der SAM, um ein stabiles System handelt. Dieses stabile System kann durch die kovalente Ausbildung zwischen der Schutzschicht und der metallischen Oberfläche erzeugt werden.

Durch die Verwendung einer Schutzschicht aus einem N-heterozyklischen Carben kann die Bauteilstabilität insgesamt gesteigert werden. Ferner kann dadurch das optoelektronische Bauelement beispielsweise in feuchtigkeitsbehafteten Gebieten eingesetzt werden. Die Lebensdauer des optoelektronischen Bauelements kann gesteigert werden. Teure Edelmetalle, beispielsweise Gold, müssen nicht mehr verwendet werden, beispielsweise für die Schichtdickenreduktion. Dies spart Kosten. Durch eine diffusionsdichte Schutzschicht kommt es auf den Diffusionskoeffizienten der Verkapselung oder des Vergusses oder auf deren Zusammensetzung nicht mehr an, sodass jede Verkapselung oder jeder beliebige Verguss unabhängig von seinen Diffusionskoeffizienten verwendet werden kann. Ferner kann durch die Verwendung einer Schutzschicht die Vermeidung von Ausfällen des optoelektronischen Bauelements durch korrosive Materialien verhindert werden. Zum anderen können auch gasdurchlässige Vergussmaterialien verwendet werden, die bei unbeschichteten metallischen Oberflächen aufgrund der Korrosion nicht verwendet werden könnten. So kann beispielsweise Epoxid als Verguss eingesetzt werden.

Die Erfindung betrifft ferner ein Verfahren zur Herstellung eines optoelektronischen Bauelements mit zumindest einer metallischen Oberfläche nach einem der Ansprüche 1 bis 7. Vorzugsweise stellt das Verfahren das optoelektronische Bauelement nach Anspruch 1 her. Dabei gelten die gleichen Definitionen und Ausführungen des optoelektronischen Bauelements auch für das Verfahren zur Herstellung des optoelektronischen Bauelements und umgekehrt. Das Verfahren umfasst folgende Verfahrensschritte:
A) Bereitstellen eines kontaktierten optoelektronischen Halbleiterchips,
B) Bereitstellen zumindest einer metallischen Oberfläche,
C) Aufbringen einer Schutzschicht auf die zumindest eine metallische Oberfläche, wobei die Schutzschicht als Schutzmaterial zumindest ein heterozyklisches Carben umfasst oder daraus besteht, wobei zwischen dem zumindest einem N-heterozyklischen Carben und der zumindest einen metallischen Oberfläche eine kovalente Bindung ausgebildet wird und wobei eine Selbstorientierung des zumindest einen N-heterozyklischen Carbens als Monolage erfolgt. Mit anderen Worten erfolgt durch die Anbindung des N-heterozyklischen Carbens an die metallische Oberfläche eine Orientierung des N-heterozyklischen Carbens innerhalb der Schutzschicht. Insbesondere erfolgt die Orientierung der N-heterozyklischen Carbene als Monolage.

Gemäß zumindest einer Ausführungsform erfolgt Schritt C) mittels Gasphasenabscheidung, insbesondere physikalischer Gasphasenabscheidung (PVD) und/oder chemischer Gasphasenabscheidung (CVD).

Gemäß zumindest einer Ausführungsform erfolgt Schritt C) mittels nasschemischer Verfahren. Insbesondere sind jegliche Verfahren geeignet, die zur Auftragung von einem N-heterozyklischen Carben aus Lösung geeignet sind. Insbesondere kann Schritt C) mittels Spincoating, Drucken, Dipcoating oder Sprühcoating erfolgen.

Gemäß zumindest einer Ausführungsform erfolgt nach Schritt C) ein zusätzlicher Schritt D):
D) Vergießen des kontaktierten optoelektronischen Halbleiterchips und der mit der Schutzschicht beschichteten metallischen Oberfläche. Damit wird die Schutzschicht Bestandteil des optoelektronischen Bauelements und verbleibt im optoelektronischen Bauelement.

Gemäß zumindest einer Ausführungsform erfolgt Schritt D) mittels eines Vergusses aus Silikon.

Weitere Vorteile, vorteilhafte Ausführungsformen und Weiterbildungen ergeben sich aus den im Folgenden in Verbindung mit den Figuren beschriebenen Ausführungsbeispielen.

Es zeigen:
- Die Figur 1A , 1B und 2 und 3: jeweils eine schematische Seitenansicht eines optoelektronischen Bauelements 100 gemäß einer Ausführungsform, und
die Figuren 4A bis 4C einen schematischen Ausschnitt einer Seitenansicht eines optoelektronischen Bauelements 100 gemäß einer Ausführungsform.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen. Vielmehr können einzelne Elemente, wie zum Beispiel Schichten, Bauteile, Bauelemente und Bereiche zur besseren Darstellbarkeit und/oder zum besseren Verständnis übertrieben groß dargestellt werden.

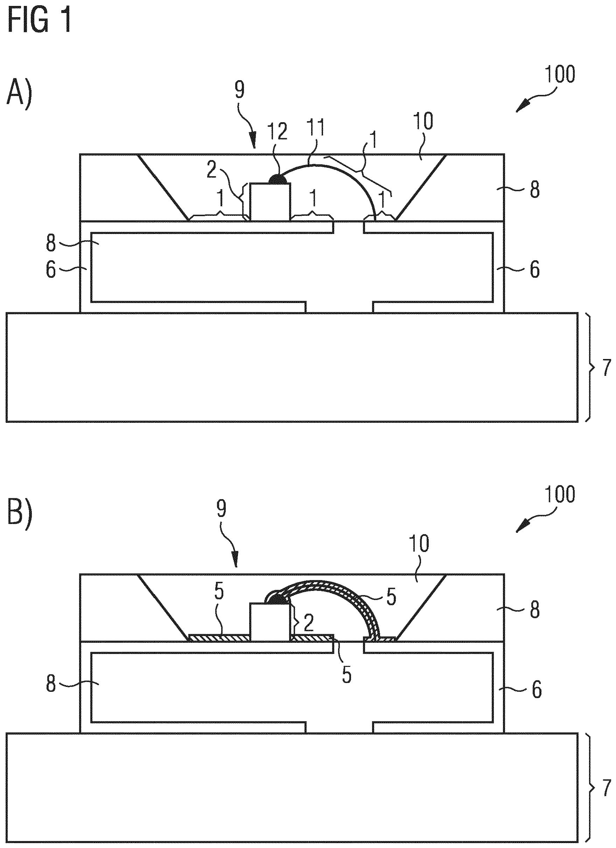

Die Figur 1A zeigt eine schematische Seitenansicht eines optoelektronischen Bauelements 100 gemäß einer Ausführungsform. Das optoelektronische Bauelement 100 weist einen Träger 7 auf. Bei einem Träger 7 kann es sich beispielsweise um ein Printed Circuit Board (PCB), ein Keramiksubstrat, eine Leiterplatte oder eine Aluminiumplatte handeln. Dem Träger 7 ist ein Gehäuse 8 nachgeordnet. Das Gehäuse 8 weist einen Leiterrahmen 6 auf. Der Leiterrahmen 6 weist elektrische Anschlussstellen auf, mit dem ein kontaktierter Halbleiterchip 2 elektrisch verbunden ist. Das Gehäuse 8 weist eine Ausnehmung 9 auf, innerhalb derer der kontaktierte Halbleiterchip 2 angeordnet ist. Der kontaktierte Halbleiterchip 2 ist auf einem Bereich des Leiterrahmens 6 angeordnet. Der Halbleiterchip 2 weist ein Bondpad 12 und einen Bonddraht 11 auf, mit dem der elektrische Anschluss über den Leiterrahmen 6 erfolgt. Das optoelektronische Bauelement 100 weist metallische Oberflächen 1 auf. Die metallischen Oberflächen 1 sind hier insbesondere die innerhalb der Ausnehmung 9 vorhandenen metallischen Oberflächen des Leiterrahmens 6 sowie des Bonddrahts 11 und des Bondpads 12. Das Bauelement 100 kann eine Schutzschicht 5 aufweisen (hier nicht gezeigt, siehe Figur 1B).

Figur 1B unterscheidet sich von der Figur 1A dadurch, dass die Schutzschicht 5 auf die metallischen Oberflächen 1 des optoelektronischen Bauelements 100 aufgebracht sind. Insbesondere ist der Bonddraht 11 formschlüssig mit der Schutzschicht 5 umhüllt. Ferner ist das Bondpad 12 formschlüssig mit der Schutzschicht 5 umhüllt. Die Schutzschicht wird insbesondere nach Aufbringen des Bonddrahts 11 und Bondpads 12 erzeugt. Insbesondere wird die Schutzschicht 5 mittels Gasphasenabscheidung oder nasschemischen Verfahren erzeugt.

Damit kann ein optoelektronisches Bauelement 100 bereitgestellt werden, das alle mit einer Schutzschicht 5 bedeckten metallischen Oberflächen 1, insbesondere innerhalb der Ausnehmung 9, aufweist. Die Schutzschicht 5 ist insbesondere diffusionsdicht gegenüber Gasen, insbesondere korrosiven Gasen, wie beispielsweise Schwefelwasserstoff. Damit kann eine Korrosion des optoelektronischen Bauelements 100 verhindert werden und damit die Langzeitstabilität des optoelektronischen Bauelements 100 erhöht werden.

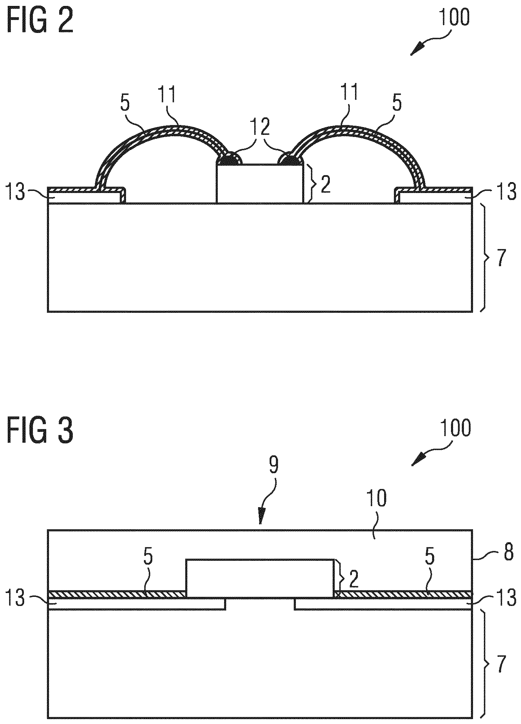

Figur 2 zeigt eine schematische Seitenansicht eines optoelektronischen Bauelements 100 gemäß einer Ausführungsform. Das optoelektronische Bauelement 100 weist einen Träger 7 auf. Dem Träger 7 sind Anschlussstellen 13 nachgeordnet. Ferner ist dem Träger 7 der kontaktierte Halbleiterchip 2 nachgeordnet. Der kontaktierte Halbleiterchip 2 weist auf seiner Strahlungsaustrittsfläche, welche dem Träger 7 abgewandt ist, zwei Bondpads 12 auf. Die Bondpads 12 werden jeweils mittels eines Bonddrahts 11 mit den Anschlussstellen 13 verbunden. Die metallischen Oberflächen 1 des optoelektronischen Bauelements 100 sind mit der Schutzschicht 5 bedeckt oder von dieser umhüllt. Das optoelektronische Bauelement 100 der Figur 2 unterscheidet sich von dem optoelektronischen Bauelement 100 der Figur 1B dadurch, dass die Kontaktierung oberhalb, das heißt über die Strahlungsaustrittsfläche des kontaktierten Halbleiterchips 2, erfolgt.

Zusätzlich kann das optoelektronische Bauelement 100 ein Verguss 10 aufweisen (hier nicht gezeigt). Figur 3 zeigt eine schematische Seitenansicht eines optoelektronischen Bauelements 100 gemäß einer Ausführungsform. Das optoelektronische Bauelement 100 weist einen Träger 7 auf. Der Träger 7 weist Anschlussstellen 13 auf. Über die Anschlussstellen 13 ist der Halbleiterchip 2 kontaktiert. Die Anschlussstellen 13 sind metallisch. Die metallischen Anschlussstellen 13 werden von der Schutzschicht 5 zumindest bereichsweise bedeckt. Das optoelektronische Bauelement 100 kann mittels eines Vergusses 10 vergossen sein.

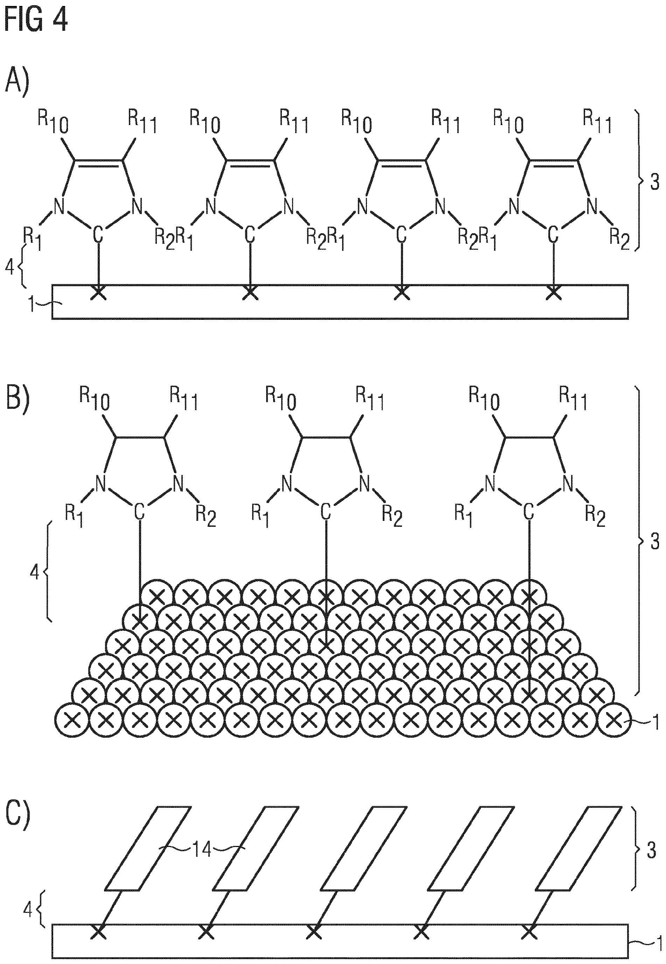

Figur 4A bis 4C zeigen jeweils einen Ausschnitt einer schematischen Seitenansicht eines optoelektronischen Bauelements 100. Die Figur 4A zeigt die metallische Oberfläche 1, die beispielsweise eine metallische Oberfläche des Bondpads 12, Bonddrahts 11 oder Anschlussstellen eines Leiterrahmens 6 sein können. Die metallische Oberfläche 1 weist Atome, beispielsweise Metallatome X, auf. Über diese Metallatome X wird das Schutzmaterial 3, welches N-heterozyklische Carbene umfasst, durch eine direkte kovalente Bindung verbunden.

Die Figur 4B zeigt die kovalente Anbindung von drei N-heterozyklischen Carbenen an die metallische Oberfläche 1. Die Schutzschicht 5 formt sich als selbstorganisierende Monoschicht oder Monolage aus. Insbesondere weist die selbstorganisierende Monoschicht eine Schichtdicke kleiner oder gleich 1 nm auf.

Figur 4C zeigt eine schematische Seitenansicht eines Ausschnitts eines optoelektronischen Bauelements 100 gemäß einer Ausführungsform. Figur 4C zeigt die Anbindung des N-heterozyklischen Carbens 14 über eine kovalente Bindung an die metallische Oberfläche 1. Mit Figur 4C soll verdeutlicht werden, dass die Moleküle, also die N-heterozyklischen Carbenmoleküle, eine selbstorganisierende Monolage ausbildet, wobei die Moleküle Längsachsen aufweisen, die zur metallischen Oberfläche 1 geneigt sind.

Diese Patentanmeldung beansprucht die Priorität der deutschen Patentanmeldung 10 2015 108 736.7.

### Bezugszeichenliste

- 100: Optoelektronisches Bauelement
- 1: metallische Oberfläche
- 2: kontaktierter Halbleiterchip
- 4: kovalente Bindung
- 5: Schutzschicht
- 14: N-heterozyklisches Carben
- 3: Schutzmaterial
- 6: Leiterrahmen
- 8: Gehäuse
- 9: Ausnehmung
- 10: Verguss
- 11: Bonddraht
- 12: Bondpad
- 13: Anschlussstellen

## Patentansprüche

1. Optoelektronisches Bauelement (100) mit zumindest einer metallischen Oberfläche (1) umfassend
- einen kontaktierten optoelektronischen Halbleiterchip (2), der zur Emission von Strahlung eingerichtet ist,
- eine Schutzschicht (5), die auf der zumindest einen metallischen Oberfläche (1) angeordnet ist,
wobei die Schutzschicht (5) ein Schutzmaterial (3) aus zumindest einem N-heterozyklischen Carben (14) umfasst, wobei zwischen dem Schutzmaterial (3) und der zumindest einen metallischen Oberfläche (1) eine kovalente Bindung (4) ausgebildet ist, das Bauelement ist **dadurch gekennzeichnet, dass** das N-heterozyklische Carben (14) 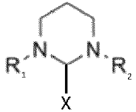 ist,
wobei R₁ und R₂ unabhängig voneinander ausgewählt sind, aus Wasserstoff, Alkylgruppen, Alkoxygruppen, Gruppen mit Aminen, Amiden, Ester, Carbonaten, substituierten oder unsubstituierten Aromaten, substituierten oder unsubstituierten Heteroaromaten, Halogenen, Pseudohalogenen, und
wobei -X eine kovalente Bindung (4) zur metallischen Oberfläche (1) ist.

2. Optoelektronisches Bauelement (100) nach Anspruch 1, wobei die Schutzschicht (5) als selbstorganisierende Monolage ausgeformt ist und eine Schichtdicke kleiner oder gleich 1 nm aufweist.

3. Optoelektronisches Bauelement (100) nach einem der vorhergehenden Ansprüche,
wobei die metallische Oberfläche (1) aus einer Gruppe ausgewählt ist, die eine Oberfläche eines ersten metallischen Anschlusskontakts, eines zweiten metallischen Anschlusskontakts, eines Leiterrahmens (6), eines Bondpads (12) und eines Bonddrahts (11) umfasst, und wobei die metallische Oberfläche (1) zumindest ein Metall oder eine Legierung umfasst, die ausgewählt ist aus: Silber, Aluminium, Cadmium, Barium, Indium, Magnesium, Kalzium, Lithium oder Gold.

4. Optoelektronisches Bauelement (100) nach einem der vorhergehenden Ansprüche,
wobei die metallische Oberfläche (1) zumindest ein Metall oder eine Legierung umfasst, die ausgewählt ist aus: Aluminium, Cadmium, Barium, Indium, Magnesium, Kalzium, Lithium, Ag:Mg, Ag:Ca oder Mg:Al.

5. Optoelektronisches Bauelement (100) nach einem der vorhergehenden Ansprüche,
wobei alle metallischen Oberflächen (1) des optoelektronischen Bauelements (100) mit der Schutzschicht (5) formschlüssig bedeckt sind.

6. Optoelektronisches Bauelement (100) nach einem der vorhergehenden Ansprüche,
wobei der kontaktierte optoelektronische Halbleiterchip (2) in einem Gehäuse (8) mit einer Ausnehmung (9) angeordnet ist, wobei die metallische Oberfläche (1) des optoelektronischen Bauelements (100) zumindest die metallischen Oberflächen eines Bondpads (12), eines Bonddrahts (11) und eines Leiterrahmens (6) umfasst, wobei die Schutzschicht (5) die metallischen Oberflächen (1) des optoelektronischen Bauelements (2) innerhalb der Ausnehmung (9) formschlüssig bedeckt, wobei die Ausnehmung mit einem Verguss (10) vergossen ist, der Silikon umfasst.

7. Optoelektronisches Bauelement (100) nach einem der vorhergehenden Ansprüche,
wobei die Schutzschicht (5) diffusionsdicht gegenüber korrosiven Gasen ist.

8. Verfahren zur Herstellung eines optoelektronischen Bauelements (100) mit zumindest einer metallischen Oberfläche (1) nach einem der Ansprüche 1 bis 7, mit den Schritten:
A) Bereitstellen eines kontaktierten optoelektronischen Halbleiterchips (2),
B) Bereitstellen zumindest einer metallischen Oberfläche (1),
C) Aufbringen einer Schutzschicht (5) auf die zumindest eine metallische Oberfläche (1), wobei die Schutzschicht (5) als Schutzmaterial (3) zumindest ein N-heterozyklisches Carben (14) umfasst, wobei zwischen dem zumindest einen N-heterozyklischen Carben (14) und der zumindest einen metallischen Oberfläche (1) eine kovalente Bindung (4) ausgebildet wird, das Verfahren ist **dadurch gekennzeichnet, dass** das N-heterozyklische Carben (14) 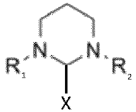 ist,
wobei R₁ und R₂ unabhängig voneinander ausgewählt sind, aus Wasserstoff, Alkylgruppen, Alkoxygruppen, Gruppen mit Aminen, Amiden, Ester, Carbonaten, substituierten oder unsubstituierten Aromaten, substituierten oder unsubstituierten Heteroaromaten, Halogenen, Pseudohalogenen, und
wobei -X eine kovalente Bindung (4) zur metallischen Oberfläche (1) ist, und eine Selbstorientierung des zumindest einen N-heterozyklischen Carbens (14) als Monolage erfolgt.

9. Verfahren nach Anspruch 8,
wobei Schritt C) mittels Gasphasenabscheidung erfolgt.

10. Verfahren nach Anspruch 8 bis 9,
wobei Schritt C) mittels nasschemischer Verfahren erfolgt.

11. Verfahren nach Anspruch 8 bis 10,
wobei nach Schritt C) ein zusätzlicher Schritt D) erfolgt:
D) Vergießen des kontaktierten optoelektronischen Halbleiterchips (2) und der mit der Schutzschicht (5) beschichteten metallischen Oberfläche (1).

12. Verfahren nach Anspruch 11,
wobei der Schritt D) mittels einem Verguss (10) aus Silikon erfolgt.

## Claims

1. Optoelectronic component (100) having at least one metallic surface (1), including
- a contacted optoelectronic semiconductor chip (2), which is configured to emit radiation,
- a protective layer (5), which is arranged on the at least one metallic surface (1),
wherein the protective layer (5) comprises a protective material (3) of at least one N-heterocyclic carbene (14), wherein a covalent bond (4) is formed between the protective material (3) and the at least one metallic surface (1), the component is **characterized in that** the N-heterocyclic carbene (14) is 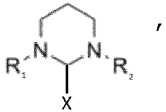 wherein R₁ and R₂ are selected independently from one another of hydrogen, alkyl groups, alkoxy groups, groups with amines, amides, esters, carbonates, substituted or unsubstituted aromatic compounds, substituted or unsubstituted heteroaromatic compounds, halogens, pseudo-halogens, and wherein -X is a covalent bond (4) to the metallic surface (1).

2. Optoelectronic component (100) according to claim 1,
wherein the protective layer (5) is formed as self-assembled monolayer and has a layer thickness equal to or smaller than 1 nm.

3. Optoelectronic component (100) according to one of the preceding claims,
wherein the metallic surface (1) is selected from a group including a surface of a first metallic connecting contact, of a second metallic connecting contact, of a lead frame (6), of a bond pad (12) and of a bond wire (11), and wherein the metallic surface (1) includes at least a metal or an alloy selected from: silver, aluminum, cadmium, barium, indium, magnesium, calcium, lithium or gold.

4. Optoelectronic component (100) according to one of the preceding claims,
wherein the metallic surface (1) comprises at least a metal or an alloy selected from: aluminum, cadmium, barium, indium, magnesium, calcium, lithium, Ag:Mg, Ag:Ca or Mg:Al.

5. Optoelectronic component (100) according to one of the preceding claims,
wherein all metallic surfaces (1) of the optoelectronic component (100) are covered with the protective layer (5) in a form-fit manner.

6. Optoelectronic component (100) according to one of the preceding claims,
wherein the contacted optoelectronic semiconductor chip (2) is arranged in a housing (8) having a recess (9), wherein the metallic surface (1) of the optoelectronic component (100) includes at least the metallic surfaces of a bond pad (12), of a bond wire (11) and of a lead frame (6), wherein the protective layer (5) covers the metallic surfaces (1) of the optoelectronic component (2) within the recess (9) in a form-fit manner, wherein the recess is potted with a potting material (10) including silicone.

7. Optoelectronic component (100) according to one of the preceding claims,
wherein the protective layer (5) is diffusion-resistant toward corrosive gases.

8. Method for producing an optoelectronic component (100) having at least one metallic surface (1) according to one of claims 1 to 7, comprising the steps of:
A) Providing a contacted optoelectronic semiconductor chip (2),
B) Providing at least one metallic surface (1),
C) Applying a protective layer (5) on to the at least one metallic surface (1), wherein the protective layer (5) includes at least one N-heterocyclic carbene (14) as a protective material (3), wherein a covalent bond (4) is formed between the at least one N-heterocyclic carbene (14) and the at least one metallic surface (1), the method being **characterized in that** the N-heterocyclic carbene (14) is 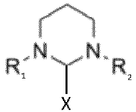 wherein R₁ and R₂ are selected independently from one another of hydrogen, alkyl groups, alkoxy groups, groups with amines, amides, esters, carbonates, substituted or unsubstituted aromatic compounds, substituted or unsubstituted heteroaromatic compounds, halogens, pseudo-halogens, and wherein -X is a covalent bond (4) to the metallic surface (1), and a self-orientation of the at least one N-heterocyclic carbene (14) is effected as a monolayer.

9. Method according to claim 8,
wherein step C) is effected by means of vapor deposition.

10. Method according to claim 8 to 9,
wherein step C) is effected by means of wet-chemical processes.

11. Method according to claim 8 to 10,
wherein an additional step D) is effected after step C):
D) Potting the contacted optoelectronic semiconductor chip (2) and the metallic surface (1) coated with the protective layer (5) .

12. Method according to claim 11,
wherein step D) is carried out by means of a potting material (10) of silicone.

## Revendications

1. Composant optoélectronique (100) ayant au moins une surface métallique (1) comprenant
- une puce optoélectronique semi-conductrice (2) en contact conçue pour l'émission d'un rayonnement,
- une couche protectrice (5) disposée sur au moins une surface métallique (1),
la couche protectrice (5) comprenant un matériau protecteur (3) composé d'au moins un carbène N-hétérocyclique (14), une liaison covalente (4) étant formée entre le matériau protecteur (3) et au moins une surface métallique (1),
le composant étant **caractérisé en ce que** le N-carbène hétérocyclique (14) est 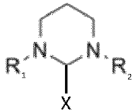
R₁ et R₂ étant choisis indépendamment parmi l'hydrogène, les groupes alkyles, les groupes alcoxy, les groupes avec aminés, les amides, les esters, les carbonates, les hydrocarbures aromatiques substitués ou non substitués, les hydrocarbures hétéroaromatiques substitués ou non substitués, les halogènes, les pseudohalogènes, et
-X étant une liaison covalente (4) avec la surface métallique (1) .

2. Composant optoélectronique (100) selon la revendication 1, dans lequel la couche protectrice (5) est formée en tant que monocouche auto-organisatrice et présente une épaisseur inférieure ou égale à 1 nm.

3. Composant optoélectronique (100) selon l'une des revendications précédentes,
dans lequel la surface métallique (1) est choisie dans un groupe comprenant une surface d'un premier contact de borne métallique, un second contact de borne métallique, une grille de connexion (6), un plot de connexion (12) et un fil de connexion (11), et dans lequel la surface métallique (1) comprend au moins un métal ou alliage choisi parmi : argent, aluminium, cadmium, baryum, indium, magnésium, calcium, lithium ou or.

4. Composant optoélectronique (100) selon l'une des revendications précédentes,
dans lequel la surface métallique (1) comprend au moins un métal ou alliage choisi parmi : aluminium, cadmium, baryum, indium, magnésium, calcium, lithium, Ag:Mg, Ag:Ca ou Mg:Al.

5. Composant optoélectronique (100) selon l'une des revendications précédentes,
dans lequel toutes les surfaces métalliques (1) du composant optoélectronique (100) sont recouvertes mécaniquement par la couche de protection (5).

6. Composant optoélectronique (100) selon l'une des revendications précédentes,
la puce optoélectronique semi-conductrice (2) en contact étant disposée dans un boîtier (8) doté d'un évidement (9), la surface métallique (1) du composant optoélectronique (100) comprenant au moins les surfaces métalliques d'un plot de connexion (12), d'un fil de connexion (11) et d'une grille de connexion (6), la couche protectrice (5) recouvrant mécaniquement les surfaces métalliques (1) du composant optoélectronique (2) à l'intérieur de l'évidement (9), l'évidement étant scellé par un scellement (10) en silicone.

7. Composant optoélectronique (100) selon l'une des revendications précédentes,
dans lequel la couche protectrice (5) est étanche à la diffusion de gaz corrosifs.

8. Procédé de fabrication d'un composant optoélectronique (100) ayant au moins une surface métallique (1) selon l'une des revendications 1 à 7, comprenant les étapes suivantes :
A) Mise à disposition d'une puce optoélectronique semi-conductrice (2) en contact,
B) Mise à disposition d'au moins une surface métallique (1),
C) Application d'une couche protectrice (5) sur au moins une surface métallique (1), la couche protectrice (5) comprenant au moins un carbène N-hétérocyclique (14) en tant que matériau protecteur (3), une liaison covalente (4) étant formée entre au moins un carbène N-hétérocyclique (14) et au moins une surface métallique (1),
le procédé étant **caractérisé en ce que** le N-carbène hétérocyclique (14) est 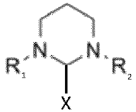
R₁ et R₂ étant choisis indépendamment parmi l'hydrogène, les groupes alkyles, les groupes alcoxy, les groupes avec aminés, les amides, les esters, les carbonates, les hydrocarbures aromatiques substitués ou non substitués, les hydrocarbures hétéroaromatiques substitués ou non substitués, les halogènes, les pseudohalogènes, et
-X étant une liaison covalente (4) avec la surface métallique (1), et au moins un carbène N-hétérocyclique (14) étant auto-orienté en tant que monocouche.

9. Procédé selon la revendication 8,
l'étape C) étant réalisée au moyen d'un dépôt en phase gazeuse.

10. Procédé selon la revendication 8 à 9,
l'étape C) étant réalisée au moyen de procédés chimiques par voie humide.

11. Procédé selon la revendication 8 à 10,
l'étape C) étant suivie d'une étape D) supplémentaire : D) Scellement de la puce optoélectronique semi-conductrice (2) en contact et de la surface métallique (1) revêtue de la couche protectrice (5).

12. Procédé selon la revendication 11,
l'étape D) étant réalisée au moyen d'un scellement en silicone (10).
